(19) Europäisches Patentamt
European Patent Office
Office européen des brevets

(11) **EP 1 739 716 A1**

(12) **EUROPÄISCHE PATENTANMELDUNG**

(43) Veröffentlichungstag:
**03.01.2007 Patentblatt 2007/01**

(51) Int Cl.:
***H01J 37/32*** *(2006.01)*     ***H05H 1/46*** *(2006.01)*

(21) Anmeldenummer: 05014414.6

(22) Anmeldetag: **02.07.2005**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(71) Anmelder: **HÜTTINGER Elektronik GmbH + Co. KG
79111 Freiburg (DE)**

(72) Erfinder:
- **Kirchmeier, Thomas
  79331 Teningen (DE)**
- **Glück, Michael
  79111 Freiburg (DE)**

- **Gerhardt, Christoph
  79106 Freiburg (DE)**
- **Mann, Ekkehard
  79194 Gundelfingen (DE)**
- **Hofstetter, Christoph
  79331 Teningen (DE)**
- **Hintz, Gerd Dr.
  79292 Pfaffenweiler (DE)**

(74) Vertreter: **Kohler Schmid Möbus
Patentanwälte
Ruppmannstrasse 27
70565 Stuttgart (DE)**

(54) **HF-Plasmaprozesssystem**

(57) Die Erfindung betrifft ein HF-Plasmaprozesssystem (100) mit einem HF-Generator (101) und einer Plasmakammer (130), wobei der HF-Generator (101) die für in der Plasmakammer (130) stattfindenden Plasmaprozesse benötigte HF-Leistung liefert, mit einer zwischen dem HF-Generator (101) und der Plasmakammer (130) angeordneten Leistungsaufteileinrichtung (103), die HF-Leistung an mindestens zwei der Plasmakammer (130, 143) zugeordneten HF-Leistungseinkoppelanschlüsse (114 - 117) liefert, wobei die Leistungsaufteileinrichtung (103) zumindest einen 90°-Hybrid (104 - 106) aufweist, der einen Absorberanschluss aufweist, an dem ein Absorbermittel(107 - 109), insbesondere ein Absorberwiderstand, angeschlossen ist. Dadurch erfolgt eine besonders einfache Leistung Aufteilung.

**Fig. 3**

EP 1 739 716 A1

**Beschreibung**

Die Erfindung betrifft ein Hochfrequenz (HF)-Plasmaprozesssystem mit einem HF-Generator und einer Plasmakammer, wobei der HF-Generator die für in der Plasmakammer stattfindenden Plasmaprozesse benötigte HF-Leistung liefert, mit einer zwischen dem HF-Generator und der Plasmakammer angeordneten Leistungsaufteileinrichtung, die HF-Leistung an mindestens zwei der Plasmakammer zugeordneten HF-Leistungseinkoppelanschlüsse liefert.

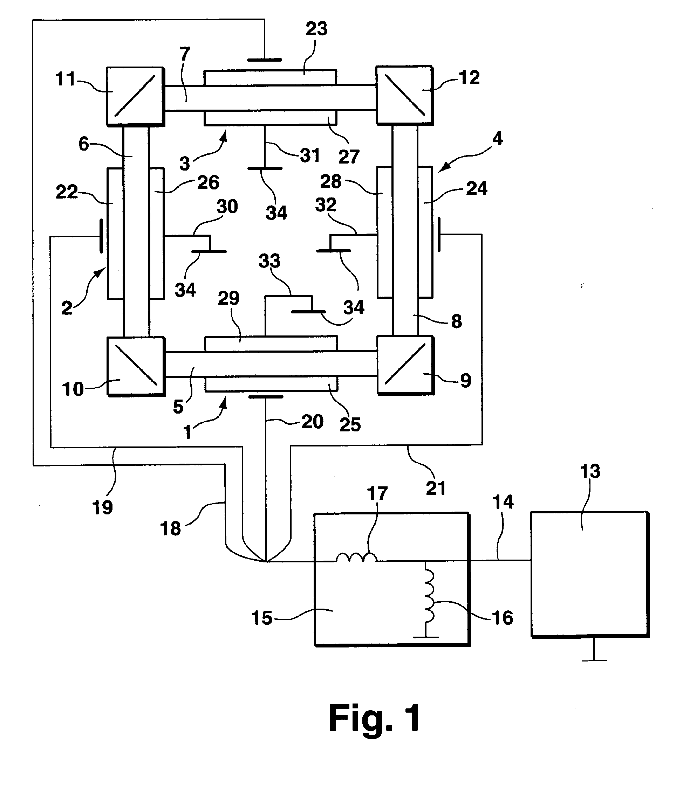

Bei der Anregung von Gaslasern mittels HF-Energie, wie dies in der Fig. 1 dargestellt ist, wird mit mehreren Elektrodenpaaren 1 - 4 ein Plasma in einer Laserröhre 5 - 8 erzeugt, wobei beispielsweise die Laserröhren 5 - 8 durch Spiegel 9 - 12 miteinander zu einem Laser - Resonator verbunden sind. Zur Anregung wird auf jedes Elektrodenpaar 1 - 4 HF-Leistung gekoppelt. Üblicherweise wird die Leistung eines einzelnen HF-Generators 13 auf alle Elektrodenpaare 1 - 4 verteilt. Dazu wird üblicherweise der HF-Generator 13 mit einem HF-Verbindungskabel 14 an ein Anpassungsglied 15 angeschlossen, das Induktivitäten 16, 17 parallel und in Reihe aufweist. Von diesem aus gehen sternförmig Leitungen 18 - 21 mit einer festen Länge zu jeweils einer Elektrode 22 - 25 eines Elektrodenpaares 1 - 4. Diese Elektrode 22 - 25 wird dann beispielsweise kapazitiv mit der Leitung 18 - 21 verbunden. Die jeweils andere Elektrode 26 - 29 wird wieder über eine Leitung 30 - 33 mit fester Länge an Masse 34 angebunden.

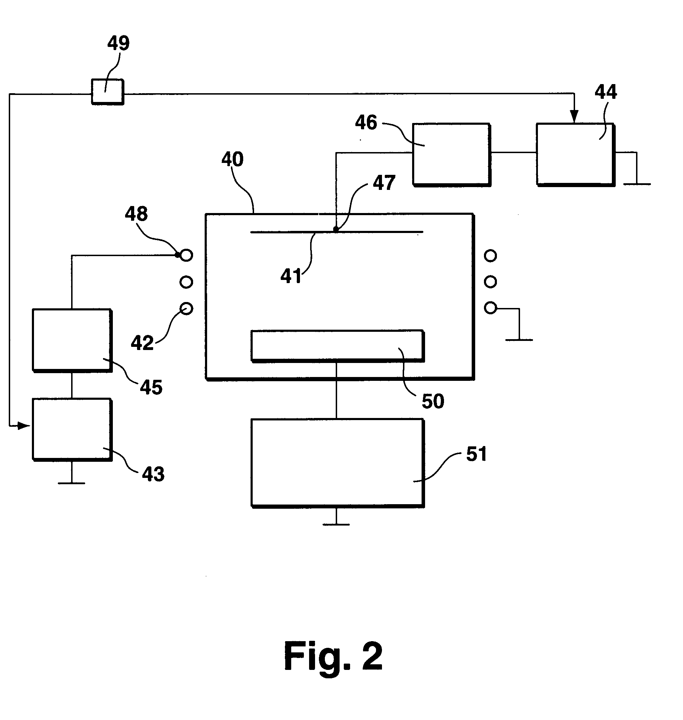

Auch bei Plasmaprozessen zur Behandlung von Werkstücken werden in bestimmten Anwendungsfällen mehrere Einkoppelstellen zum Einkoppeln von HF-Leistung benötigt, wie dies beispielsweise in der Fig. 2 dargestellt ist. Dabei gibt es bei Plasmaprozessen prinzipiell mehrere Möglichkeiten der Einkopplung in die Plasmakammer 40:

    1. über großflächige Elektroden 41 wird kapazitiv eingekoppelt;
    2. über Spulen 42 wird induktiv eingekoppelt;
    3. es wird über eine Elektrode 41 kapazitiv und eine Spule 42 induktiv eingekoppelt.

Weiterhin besteht die Möglichkeit, dass zusätzlich zu der induktiven Einkopplung ein kapazitiver Schirm eingesetzt wird, der bestimmte Bereiche der Plasmakammer 40 vor dem Plasma schützen soll.

Für die oben genannte Mehrfacheinkopplung von HF-Leistung werden üblicherweise mehrere HF-Leistungsgeneratoren 43, 44 mit je einem Impedanzanpassungsglied 45, 46 eingesetzt und jeder Einkoppelanschluss 47, 48 von einem eigenen HF-Generator 43, 44 angesteuert. Die HF-Generatoren 43, 44 müssen in der Regel über eine Synchronisationseinrichtung 49 synchronisiert werden. Zu erwähnen ist noch, dass in der Plasmakammer 40 in der Regel ein Substrat 50 angeordnet ist, das über eine Spannungsversorgung 51 mit elektrischer Spannung versorgt wird.

Es gibt aber auch die Möglichkeit, mit einem HF-Generator und einem Impedanzanpassungsglied mit mehreren Ausgängen die Leistung auf unterschiedliche Elektroden und/oder Spulen zu verteilen.

Aufgabe der vorliegenden Erfindung ist es, ein HF-Plasmaprozesssystem der eingangs genannten Art so weiterzubilden, dass eine gezielte und verlustarmen Aufteilung von HF-Leistung des HF-Generators auf unterschiedliche HF-Leistungseinkoppelanschlüsse ermöglicht wird.

Diese Aufgabe erfindungsgemäß auf ebenso überraschend einfache wie wirkungsvolle Art und Weise dadurch gelöst, dass bei einem HF-Plasmaprozesssystem der eingangs genannten Art die Leistungsaufteileinrichtung zumindest einen 90°-Hybrid aufweist, der einen Absorberanschluss aufweist, an dem ein Absorbermittel, insbesondere ein Absorberwiderstand, angeschlossen ist. Somit können weniger, dafür aber leistungsfähigere HF-Generatoren eingesetzt werden als im Stand der Technik, um an mehreren Stellen HF-Leistung für einen Plasmaprozess bereitzustellen. Synchronisationseinrichtungen können entfallen. 90°-Hybride besitzen den Vorteil, dass Reflexionen und Oberwellen zumindest teilweise im Absorberwiderstand absorbiert werden. Die HF-Leistungsgeneratoren müssen weniger robust sein, da ein Großteil der Störungen im Absorberwiderstand bleibt. Das gilt ganz besonders für HF-Leistungsgeneratoren, bei denen der Ausgangsverstärker nicht eine Verstärkerröhre ist, sondern eine Vielzahl von Halbleiterbausteinen, z.B. MOS-FET Transistoren, die viel empfindlicher auf Störungen reagieren, aufweist.

Wenn die Leistungsaufteileinrichtung eine Kaskade mehrerer 90°-Hybride aufweist, kann die HF-Leistung eines HF Generators nicht nur an zwei sondern auch an mehrere HF-Leistungseinkoppelanschlüsse aufgeteilt werden. Außerdem kann die Ausgangsleistung des HF-Generators prinzipielle in beliebig viele Anteile aufgeteilt werden. Die Absorption von Störungen in den Absorberwiderständen verbessert sich mit jeder Kaskade, und es müssen deutlich weniger Maßnahmen getroffen werden, um die HF-Leistungsgeneratoren vor den Störungen zu schützen.

Bei einer Ausgestaltung kann vorgesehen sein, dass zumindest ein 90°-Hybrid als 3dB-Koppler ausgebildet ist. Ein 3dB-Koppler teilt die am Eingang anliegende Leistung hälftig auf seine beiden Ausgänge auf.

Bei einer Ausführungsform kann vorgesehen sein, dass zumindest ein 90°-Hybrid nicht als 3dB-Koppler ausgebildet ist. Dadurch können unterschiedliche Teilerverhältnisse für die Aufteilung der HF-Leistung realisiert werden. Zum Beispiel teilt ein 4,8dB-Koppler die Leistung im Verhältnis 1/3 zu 2/3. Wird einem 4,8dB-Koppler an seinem Ausgang, an dem 2/3 der Eingangsleistung anliegen, ein 3dB-Koppler nachgeschaltet, so wird beispielsweise die Leistung des HF-Leistungsgenerator auf drei Ausgänge verteilt, wobei an jedem Ausgang dieselbe Leistung abgegeben wird.

Je nach gewünschter Leistungsaufteilung kann auch vorgesehen sein, dass kein 90°-Hybrid als 3dB-Koppler ausgebildet ist.

Reflexionen und Verluste können minimiert werden, wenn zwischen der Leistungsaufteileinrichtung und zumindest einem Leistungseinkoppelanschluss ein Impedanzanpassungsglied angeordnet ist.

Die Ausgangssignale eines 90°-Hybriden haben eine Phasendifferenz von 90°. Bei einer Kaskade von mehreren 90°-Hybriden ergibt sich eine weitere Phasenindifferenz. Die so vorgegebenen Phasendifferenzen könne jedoch beeinflusst werden, wenn vor oder nach zumindest einem Impedanzanpassungsglied ein Phasenkorrekturglied vorgesehen ist. Dies kann je nach Anwendung notwendig sein.

Bei einer bevorzugten Ausführungsform ist zumindest ein Leistungseinkoppelanschluss an eine Elektrode der Plasmakammer angekoppelt. Unter Einkopplung wird dabei eine unmittelbare elektrische Verbindung verstanden, d.h. der Leistungseinkoppelanschluss ist direkt mit einer Elektrode der Plasmakammer verbunden. Unter einer Einkopplung wird jedoch auch eine kapazitive oder induktiven Einkopplung verstanden. Bei einer kapazitiven Einkopplung ist der Leistungseinkoppelanschluss in unmittelbarer Nähe, jedoch beabstandet von der Elektrode der Plasmakammer angeordnet. Unabhängig davon, ob der Leistungseinkoppelanschluss unmittelbar oder berührungslos an die Elektrode angekoppelt ist, wird über eine Elektrode HF-Leistung in der Regel kapazitiv in die Plasmaanlage eingekoppelt.

Eine induktive Einkopplung von HF-Leistung in einen Plasmaprozess kann erfolgen, wenn zumindest ein Leistungseinkoppelanschluss an eine Einkoppelspule angekoppelt ist.

Besondere Vorteile ergeben sich, wenn zumindest zwei Leistungseinkoppelanschlüsse an unterschiedliche Anzapfpunkte einer Einkoppelspule angekoppelt sind. Dabei ist es denkbar, dass die beiden Enden der Einkoppelspule jeweils mit einem Leistungseinkoppelanschluss gekoppelt sind. Beispielsweise kann zwischen den Ausgängen von 90°-Hybriden eine Last, also insbesondere eine Spule, zu induktiven Einkopplung geschaltet werden. Wenn die Spule mit ihren beiden Enden jeweils an einem Leistungseinkoppelanschluss angeschlossen ist, ist die Spule massefrei und die HF-Leistung kann symmetrisch auf das Plasma der Plasmakammer verteilt werden. Es ist jedoch auch denkbar, einen Anzapfpunkt an einem Ende der Spule anzubringen und den anderen Anzapfpunkt von beiden Enden beabstandet an einer anderen Stelle der Spule anzuschließen. Somit kann Leistung induktiv aber phasenversetzt über die Einkoppelspule in das Plasma eingekoppelt werden.

Die Erfindung kann vorteilhaft eingesetzt werden, wenn die Plasmakammer als Beschichtungskammer oder Ätzkammer ausgebildet ist. Ein weiteres Anwendungsgebiet ergibt sich, wenn die Plasmakammer als Laser-Resonator eines Gaslasersystems ausgebildet ist.

Besonders bevorzugt ist es, wenn der HF-Leistungsgenerator einen geschalteten HF-Verstärker umfasst. Diese können relativ kostengünstig bei geringen Maßen aufgebaut werden. Auch sind geschaltete Verstärker besonders empfindlich gegenüber Störungen, wie z.B. Reflexionen oder Oberwellen, die von der Plasmakammer kommen. Deswegen ist der Einsatz von 90°-Hybriden gerade bei diesen Verstärkern besonders vorteilhaft, weil die Störungen in den Absorbermitteln absorbiert werden.

Bei einer Weiterbildung kann vorgesehen sein, dass der geschaltet HF-Verstärker mehrere Halbleitermodule aufweist. Durch die Verwendung von 90°-Hybriden können diese gefahrlos eingesetzt werden, da Reflexionen weitestgehend unterbunden werden und in den Absorberwiderstand abgeleitet werden. Somit werden geschaltete HF-Verstärker durch 90°-Hybride optimal geschützt.

Vorzugsweise ist der HF-Leistungsgenerator zur Erzeugung von HF-Leistung bei einer Grundfrequenz im Bereich 10 - 100 MHz, insbesondere von 10 bis 30MHz, ausgebildet. In diesem Bereich liegen die wichtigen Industriefrequenzen 13MHz und 27MHz, bei denen viele Plasmaprozesse vorteilhaft betrieben werden. In diesem Bereich werden HF-Leistungsgeneratoren mit geschalteten HF-Verstärkern aus Halbleitermodulen in verstärktem Maß eingesetzt, wobei diese aber immer Schwierigkeiten mit den Störungen von der Plasmakammer besitzen. Da der Einsatz von 90°-Hybriden in der erfindungsgemäßen Ausführung in diesem Frequenzbereich neu ist, können nun Prozesse mit großem Störpotential erstmalig mit HF-Leistungsgeneratoren mit geschalteten HF-Verstärkern, insbesondere mit solchen, deren Ausgangsstufen aus Halbleitermodulen aufgebaut sind, betrieben werden.

Besonders bevorzugt ist das Plasmaprozesssystem mit einem HF-Leistungsgenerator mit einer Nennausgangsleistung größer 1kW insbesondere größer 10kW, ausgebildet. Von der Industrie werden in zunehmendem Maße Leistungsgeneratoren immer größerer Leistung gefordert, gleichzeitig sollen die Leistungsgeneratoren immer kleiner und leichter sein, eine immer bessere Effizienz aufweisen und gleichzeitig immer störsicherer und kostengünstiger sein. Um Größe, Gewicht und Kosten zu reduzieren, werden in zunehmendem Maße geschaltete Leistungsverstärker mit Halbleitermodulen eingesetzt. Es hat sich aber gezeigt, dass diese deutlich störanfälliger sind als die seither eingesetzten Röhrenverstärker. Hier kann die Erfindung Abhilfe schaffen, da die Störanfälligkeit drastisch reduziert wird.

Bei einer besonders bevorzugten Ausführungsform umfasst der 90°-Hybrid mindestens einen ersten und einen zweiten elektrischen Leiter, die voneinander beabstandet sind, und die kapazitiv und induktiv miteinander gekoppelt sind, wobei der erste Leiter die Primärseite und der zweite Leiter die Sekundärseite eines Übertragers darstellen. Grundsätzlich kann ein 90°-Hybrid auch aus diskreten Bauteilen aufgebaut werden, wobei der 90°-Hybrid in der Regel mindestens eine Kapazität zur kapazitiven Kopplung und einen Übertrager mit einer Koppelinduktivität zur induktiven magnetischen Kopplung aufweist.

Damit sich das gewünscht Verhalten des 90°-Hybrids einstellt, sollten die Koppelinduktivität und die Koppelkapazität die folgenden Bedingungen erfüllen:

$$L_K = Z_0 / (2 \pi f)$$

$$C_K = 1 / (2 \pi f Z_0)$$

wobei gilt:

$L_K$ = Koppelinduktivität
$C_K$ = Koppelkapazität
$Z_0$ = Wellenwiderstand
f = Frequenz

Bei 13MHz und $Z_0$ = 50Ω ergibt sich dann eine Koppelinduktivität $L_K$ von ca. 600nH und eine Koppelkapazität $C_K$ von ca. 200pF.

Der Aufbau eines 90°-Hybrids aus diskreten Bauteilen erfordert immer einen hohen Aufwand an präzisen Bauteilen, die unter Umständen auch noch abgeglichen werden müssen. Insbesondere für größere Leistungen (größer 1kW) ist dies sehr kostspielig.

Die Koppelkapazität kann mittels zweier beabstandeter elektrischer Leiter mit einer definierten Fläche und einem definierten Abstand zueinander einfach, kostengünstig und sehr präzise reproduzierbar realisiert werden.

Wird die erforderliche Induktivität mittels zweier solcher Leiter nicht erreicht, besteht eine Möglichkeit darin, die Induktivität mit Induktivitätserhöhungselementen, z.B. Ferriten, die insbesondere im Kopplungsbereich der Leiter anzuordnen sind, zu erhöhen. Um auf die notwendige Induktivität bei großen Leistungen zu kommen, sind Induktivitätserhöhungselemente mit großen Abmessungen und hohen Kosten notwendig. Zusätzlich oder alternativ kann daher vorgesehen sein, dass der erste und der zweite Leiter jeweils eine Windungszahl n > 1 aufweisen. Durch diese einfache Maßnahme kann die Induktivität auf einfache Art und Weise erhöht werden. Die Induktivität steigt mit der Anzahl der Windungen im Quadrat, mit einer Verdopplung der Windungszahl erhöht sich die Induktivität demnach um den Faktor vier. Die Größe eines Induktivitätserhöhungselements kann sich demnach bei der Verdopplung der Windungszahl um den Faktor 4 verkleinern. Damit kann die Baugröße durch Verwendung von mehr als einer Windung reduziert werden. Bei einer ausreichend hohen Windungszahl kann im Idealfall auf weitere induktivitätserhöhende Maßnahmen verzichtet werden. Durch eine erhöhte Windungszahl kann aber auch die Länge die die Induktivität erzeugenden Leiter reduziert werden.

Die Abmessungen, d.h. die Ausdehnung in allen Dimensionen des 90°-Hybrids, insbesondere für Frequenzen unter 100 MHz, insbesondere unter 30MHz, können deutlich reduziert werden. Sie können kleiner als λ/4, insbesondere kleiner als λ/8 und vorzugsweise sogar kleiner als λ/10 betragen. Bei diesen Größen haben die Einflüsse der Leitungstheorie der Hochfrequenztechnik keine Bedeutung mehr. Ausdrücklich sei hier erwähnt, dass es sich bei dem 90°-Hybrid im Rahmen dieser Erfindung nicht um einen Leitungskoppler handelt, wie er aus dem Stand der Technik für höhere Frequenzen bekannt ist. Die Charakterisitk des 90°-Hybrids wird nicht (ausschließlich) durch die Leitungslänge bestimmt. Vielmehr entspricht die Kopplung zwischen den elektrischen Leitern einer kapazitiven Kopplung mit einer fest vorgebenen und eingestellten Kapazität zwischen den Leitern bei vorgegebener Grundfrequenz f und vorgegebenem Wellenwiderstand $Z_0$. Die Kapazität kann über die Fläche und den Abstand der Leiter eingestellt werden. Da die äußeren Abmessungen des 90°-Hybriden vorzugsweise < λ/10 sind, ist auch die Leistungslänge der Leiter des 90°-Hybriden vorzugsweise < λ/10.

Weiterhin entspricht die Kopplung einer induktiven Kopplung mit einer fest vorgegebenen und eingestellten Induktivität des Übertragers bei vorgegebener Grundfrequenz f und vorgegebenem Wellenwiderstand $Z_0$. Die Induktivität wird beispielsweise abhängig von der Länge der Leiter eingestellt.

Weitere Merkmale und Vorteile der Erfindung ergeben sich aus der nachfolgenden Beschreibung von Ausführungsbeispielen der Erfindung, anhand den Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:

Fig. 1    ein HF-Plasmaprozesssystem nach dem Stand der Technik;

Fig. 2    ein zweites HF-Plasmaprozesssystem nach dem Stand der Technik;

Fig. 3    ein erfindungsgemäßes HF-Plasmaprozesssystem mit einer drei 90°-Hybride aufweisenden Leistungsaufteileinrichtung;

Fig. 4    ein HF-Plasmaprozesssystem mit induktiver HF- Leistungseinkopplung;

Fig. 5    ein HF-Plasmaprozesssystem mit induktiver HF- Leistungseinkopplung, wobei HF-Leistung an beiden Enden der Einkoppelspule eingespeist wird;

Fig. 6 ein HF-Plasmaprozesssystem mit induktiver HF- Leistungseinkopplung, wobei HF-Leistung an zwei Anzapfpunkten der Einkoppelspule eingespeist wird;

Fig. 7 ein Ausführungsbeispiel zur Verdeutlichung der Leistungsaufteilung mit unterschiedlichen 90°-Hybriden.

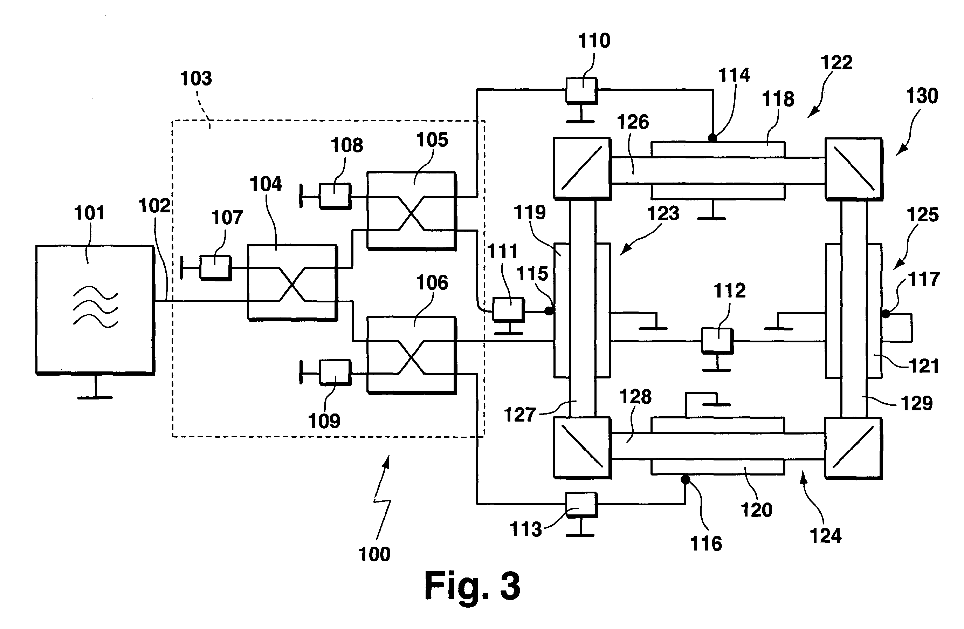

In der Fig. 3 ist eine erste Ausführungsformen eines HF-Plasmaprozesssystems 100 dargestellt. Dieses umfasst einen HF-Generator 101, der über eine Verbindungsleitung 102 an eine Leistungsaufteileinrichtung 103 angeschlossen ist. Die Leistungsaufteileinrichtung 103 umfasst drei 90°-Hybride 104 - 106, die im Ausführungsbeispiel als 3dB-Koppler ausgebildet sind. Die 90°-Hybride 105, 106 sind mit ihren Eingängen an die Ausgänge des 90°-Hybrids 104 angeschlossen und diesem dadurch nachgeschaltet bzw. zu diesem kaskadiert. An jedem 3dB-Koppler wird die Eingangsleistung halbiert, so dass jeweils die halbe Eingangsleistung an einem Ausgang anliegt.

Die 90°-Hybride 104 - 106 weisen jeweils ein Absorbermittel 107 - 109 auf, das als Absorberwiderstand ausgebildet ist. In diesem Absorbermittel 107 - 109 wird Leistung bei Fehlanpassung bzw. bei reflektierter Leistung absorbiert. Dadurch wird vermieden, dass Leistung in Mehrfachreflexionen zwischen HF-Generator 101 und Ausgängen der Leistungsaufteileinrichtung 103 den HF Generator 101 beschädigt, insbesondere einen darin vorhandenen HF-Verstärker.

Über Impedanzanpassungsglieder 110 - 113 wird jeweils 1/4 der vom HF-Generator 101 gelieferten Leistung an einen Leistungseinkoppelanschluss 114 - 117 gegeben. Die Leistungseinkoppelanschlüsse 114 - 117 werden an Elektroden 118 - 121 von Elektrodenpaaren 122 - 125 angekoppelt. Die Elektrodenpaare 122 - 125 sind Laserröhren 126 - 129 zugeordnet, die zusammen eine als Laser-Resonator ausgebildete Plasmakammer 130 bilden. Dies bedeutet, dass im Ausführungsbeispiel die Leistung des HF-Generators 101 symmetrisch auf die Laserröhren 126 - 129 verteilt wird. Wäre einer der 90°-Hybriden 104 - 106 nicht als 3dB-Koppler ausgebildet, würde eine unsymmetrische Leistungsaufteilung erfolgen, was in manchen Anwendungsfällen erwünscht sein kann.

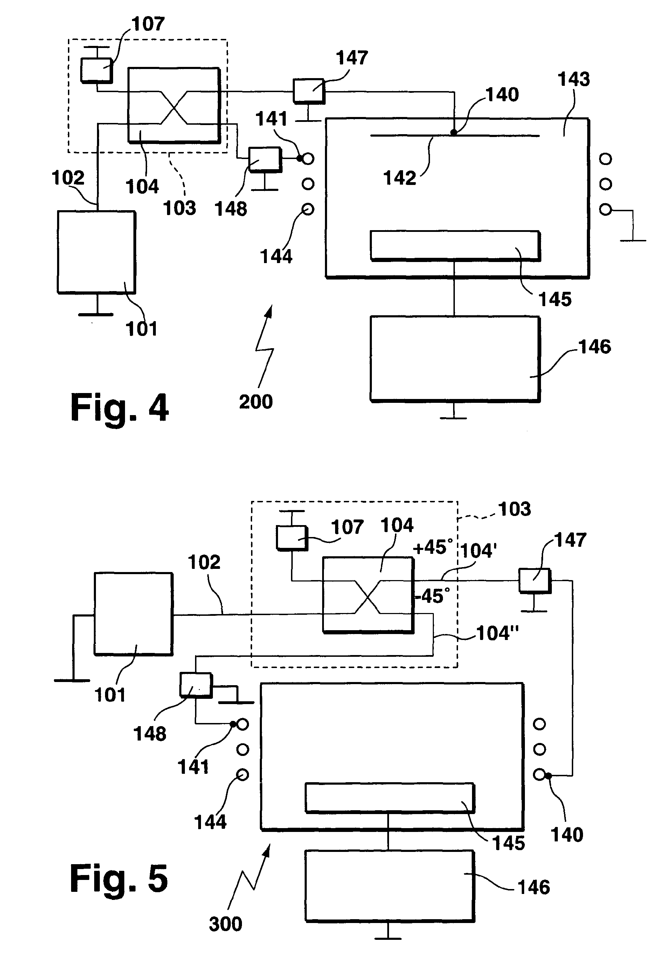

Beim Ausführungsbeispiel der Fig. 4 ist ein HF-Plasmaprozesssystem 200 gezeigt, welches einen HF-Generator 101 aufweist, der über eine Verbindungsleitung 102 an eine Leistungsaufteileinrichtung 103 angeschlossen ist, die einen 90°-Hybrid 104 aufweist, der als 3dB-Koppler ausgebildet ist. Die vom HF-Generator 101 gelieferte HF-Leistung wird somit auf die zwei Leistungseinkoppelanschlüsse 140, 141 aufgeteilt, wobei der Leistungseinkoppelanschluss 140 an eine Elektrode 142 zur kapazitiven Einkopplung von HF-Leistung in die Plasmakammer 143 angekoppelt ist und der Leistungseinkoppelanschluss 141 an eine Einkoppelspule 144 zur induktiven Leistungseinkopplung in die Plasmakammer 143 angekoppelt ist. Ein Substrat 145 ist an eine Spannungsversorgung 146 angeschlossen.

Das Ausführungsbeispiel eines HF-Plasmaprozesssystems 300 der Fig. 5 weist im Unterschied zur Fig. 4 keine Elektrode zur kapazitiven Leistungseinkopplung auf. Vielmehr ist der Leistungseinkoppelanschluss 140 an das dem Leistungseinkoppelanschluss 141 gegenüberliegende Ende der Einkoppelspule 144 angekoppelt. Da an den beiden Ausgängen 104' und 104" des 90°-Hybrids 104 Leistungssignale mit einem Phasenversatz von 90° anliegen, wird an den beiden Leistungseinkoppelanschlüssen 141, 140 Leistung mit unterschiedlichen Phasenlagen in die Einkoppelspule 144 eingekoppelt. Die Einkoppelspule 144 ist dadurch massefrei. Bezogen auf die Phase des Eingangssignals des 90°-Hybriden 104 weist das Signal am Ausgang 104' einen Phasenversatz von +45° und am Ausgang 104" einem Phasenversatz von -45° auf.

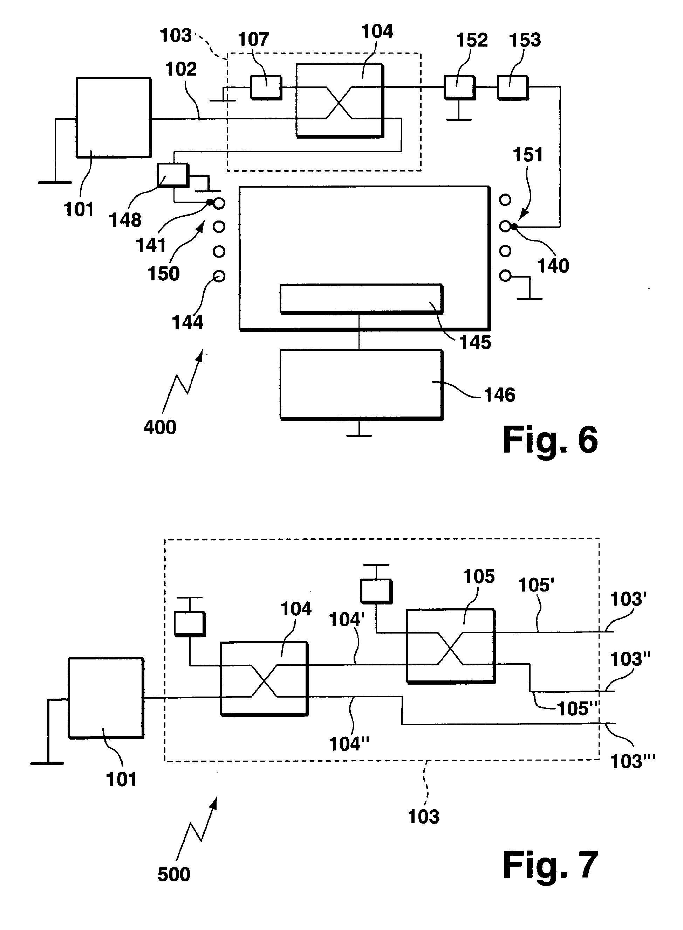

Gemäß dem Ausführungsbeispiel der Fig. 6 eines HF-Plasmaprozesssystems 400 ist der Leistungseinkoppelanschluss 141 mit einem ersten Anzapfpunkt 150 an einem Ende der Einkoppelspule 144 verbunden und ist der Leistungseinkoppelanschluss 140 mit einem zweiten Anzapfpunkt 151 verbunden. Das dem Anzapfpunkt 150 gegenüberliegende Ende der Einkoppelspule 144 ist an Masse 152 angeschlossen. Der Anzapfpunkt 151 liegt also vom Masseanschluss der Einkoppelspule 140 beabstandet. Vor dem Leistunseinkoppelanschluss 140 sind ein Impedanzanpassungsglied 152 und ein Phasenkorrekturglied 153 angeordnet.

In der Fig. 7 ist ein HF-Plasmaprozesssystem 500 nur teilweise dargestellt. Die Leistungsaufteileinrichtung 103 weist zwei 90°-Hybride 104, 105 auf. Der erste 90°-Hybrid 104 ist als 4,8dB-Koppler ausgebildet, so dass an seinem Ausgang 104' 2/3 und an seinem Ausgang 104" 1/3 der Eingangsleistung anliegt. Der 90°-Hybrid 105 ist mit seinem Eingang an den Ausgang 104' des 90°-Hybriden 104 angeschlossen. Der 90°-Hybrid 105 ist als 3dB-Koppler ausgebildet. Dies bedeutet, dass an den Ausgängen 105' und 105" jeweils 1/3 der Eingangsleistung des 90°-Hybriden 104 anliegt. Dies bedeutet weiterhin, dass an allen drei Ausgängen 103', 103", 103''' der Leistungsaufteileinrichtung 103 dieselbe Ausgangsleistung anliegt, nämlich 1/3 der vom HF-Generator 101 gelieferten Leistung.

**Patentansprüche**

1. HF-Plasmaprozesssystem (100, 200, 300, 400, 500) mit einem HF-Generator (101) und einer Plasmakammer (130, 143), wobei der HF-Generator (101) die für in der Plasmakammer (130, 143) stattfindenden Plasmaprozesse benötigte HF-Leistung liefert, mit einer zwischen dem HF-Generator (101) und der Plasmakammer (130, 143) angeordneten Leistungsaufteileinrichtung (103), die HF-Leistung an mindestens zwei der Plasmakammer (130, 143) zugeordneten HF-Leistungseinkoppelanschlüsse (114 - 117, 140, 141) liefert, **dadurch gekennzeichnet, dass** die Leistungsaufteileinrichtung (103) zumindest einen 90°-Hybrid (104 - 106) aufweist, der einen Absorberanschluss aufweist, an dem ein Absorbermittel(107 - 109), insbesondere ein Absorberwiderstand, angeschlossen ist.

2. HF-Plasmaprozesssystem nach Anspruch 1, **dadurch gekennzeichnet, dass** die Leistungsaufteileinrichtung (103) eine Kaskade mehrerer 90°-Hybride (104 - 106) aufweist.

3. HF-Plasmaprozesssystem nach einem der vorhergehenden Ansprüche, **dadurch gekennzeichnet, dass** zumindest ein 90°-Hybrid (104 - 106) als 3dB-Koppler ausgebildet ist.

4. HF-Plasmaprozesssystem nach einem der vorhergehenden Ansprüche, **dadurch gekennzeichnet, dass** zumindest ein 90°-Hybrid (104 - 106) nicht als 3dB-Koppler ausgebildet ist.

5. HF-Plasmaprozesssystem nach einem der vorhergehenden Ansprüche 1, 2, 4, **dadurch gekennzeichnet, dass** kein 90°-Hybrid (104 - 106) als 3dB-Koppler ausgebildet ist.

6. HF-Plasmaprozesssystem nach einem der vorhergehenden Ansprüche, **dadurch gekennzeichnet, dass** zwischen der Leistungsaufteileinrichtung (103) und zumindest einem Leistungseinkoppelanschluss (114 - 117, 140, 141) ein Impedanzanpassungsglied (110 - 113, 152) angeordnet ist.

7. HF-Plasmaprozesssystem nach Anspruch 6, **dadurch gekennzeichnet, dass** vor oder nach zumindest einem Impedanzanpassungsglied (152) ein Phasenkorrekturglied (153) vorgesehen ist.

8. HF-Plasmaprozesssystem nach einem der vorhergehenden Ansprüche, **dadurch gekennzeichnet, dass** zumindest ein Leistungseinkoppelanschluss (114 - 117, 140, 141) an eine Elektrode (118 - 121, 142) der Plasmakammer (130, 143) angekoppelt ist.

9. HF-Plasmaprozesssystem nach einem der vorhergehenden Ansprüche, **dadurch gekennzeichnet, dass** zumindest ein Leistungseinkoppelanschluss (114 - 117, 140, 141) an eine Einkoppelspule (144) angekoppelt ist.

10. HF-Plasmaprozesssystem nach einem der vorhergehenden Ansprüche, **dadurch gekennzeichnet, dass** zumindest zwei Leistungseinkoppelanschlüsse (140, 141) an unterschiedliche Anzapfpunkte (150, 151) einer Einkoppelspule (144) angekoppelt sind.

11. HF-Plasmaprozesssystem nach einem der vorhergehenden Ansprüche, **dadurch gekennzeichnet, dass** die Plasmakammer (143) als Beschichtungskammer oder Ätzkammer ausgebildet ist.

12. HF-Plasmaprozesssystem nach einem der vorhergehenden Ansprüche, **dadurch gekennzeichnet, dass** die Plasmakammer (130) als Laser-Resonator eines Gaslasersystems ausgebildet ist.

13. HF-Plasmaprozesssystem nach einem der vorhergehenden Ansprüche, **dadurch gekennzeichnet, dass** der HF-Leistungsgenerator (101) einen geschalteten HF-Verstärker umfasst.

14. HF-Plasmaprozesssystem nach Anspruch 13, **dadurch gekennzeichnet, dass** der geschaltet HF-Verstärker (101) mehrere Halbleitermodule aufweist.

15. HF-Plasmaprozesssystem nach einem der vorhergehenden Ansprüche, **dadurch gekennzeichnet, dass** der 90°-Hybrid mindestens einen ersten und einen zweiten elektrischen Leiter umfasst, die voneinander beabstandet sind und die kapazitiv und induktiv miteinander gekoppelt sind, wobei der erste Leiter die Primärseite und der zweite Leiter die Sekundärseite eines Übertragers darstellen.

16. HF-Plasmaprozesssystem nach Anspruch 15, **dadurch gekennzeichnet, dass** der erste und der zweite Leiter jeweils eine Windungszahl n > 1 aufweisen.

17. HF-Plasmaprozesssystem nach einem der vorhergehenden Ansprüche 15 oder 16, **dadurch gekennzeichnet, dass** in einem Kopplungsbereich zur Erhöhung der Induktivität der Leiter zumindest ein Induktivitätserhöhungselement vorgesehen ist.

18. HF-Plasmaprozesssystem nach einem der vorhergehenden Ansprüche 15 bis 17, **dadurch gekennzeichnet, dass** die räumliche Ausdehnung des 90°-Hybrid (104 - 106) in jeder beliebigen Dimension < λ/10 ist.

19. HF-Plasmaprozesssystem nach einem der vorhergehenden Ansprüche, **dadurch gekennzeichnet, dass** der HF-Leistungsgenerator (101) zur Erzeugung von HF-Leistung bei einer Grundfrequenz im Bereich 10 - 100 MHz, insbesondere von 10 bis 30MHz, ausgebildet ist

**20.** HF-Plasmaprozesssystem nach einem der vorhergehenden Ansprüche, **dadurch gekennzeichnet, dass** der HF-Leistungsgenerator (101) als HF-Leistungsgenerator mit einer Nennausgangsleistung größer 1kW, insbesondere größer 10kW, ausgebildet ist.

**Fig. 1**

# Fig. 2

Fig. 3

## Fig. 4

## Fig. 5

**Fig. 6**

**Fig. 7**

EP 1 739 716 A1

**Europäisches Patentamt**

**EUROPÄISCHER RECHERCHENBERICHT**

Nummer der Anmeldung

EP 05 01 4414

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 5 637 961 A (ISHII ET AL) 10. Juni 1997 (1997-06-10) * Spalte 2, Zeile 51 - Spalte 3, Zeile 18 * * Spalte 4, Zeile 41 - Spalte 5, Zeile 1 * * Spalte 8, Zeile 19 - Zeile 22 * | 1-3,6-9, 11,19,20 | H01J37/32 H05H1/46 |
| Y | * Abbildungen 1-3,6-8 * | 4,5,10, 12-15 | |
| Y | WO 98/01946 A (HARRIS, CLIFFORD; UNGVARSKY, CARL; CORREA, PAULO) 15. Januar 1998 (1998-01-15) * Seite 38, Absatz 2 - Seite 39, letzter Absatz; Abbildung 18 * | 4,5 | |
| Y | WO 00/17906 A (APPLIED MATERIALS, INC) 30. März 2000 (2000-03-30) * Abbildungen 3a-5 * | 10 | |
| Y | US 4 864 587 A (JAVAN ET AL) 5. September 1989 (1989-09-05) * Spalte 3, Zeile 49 - Zeile 64 * | 12 | |
| Y | US 2004/263412 A1 (PRIBYL PATRICK) 30. Dezember 2004 (2004-12-30) * Absatz [0067] - Absatz [0068] * * Abbildung 5 * | 13,14 | |
| Y | US 6 667 487 B1 (SIMS, III WILLIAM HERBERT ET AL) 23. Dezember 2003 (2003-12-23) * Spalte 5, Zeile 57 - Zeile 65 * * Abbildung 2 * | 15 | |
| A | US 2003/215373 A1 (REYZELMAN LEONID E ET AL) 20. November 2003 (2003-11-20) * Absatz [0056] * * Absatz [0067] - Absatz [0069] * * Absatz [0098] * * Abbildungen 2-3b * | 1-3,6,11 | |

RECHERCHIERTE SACHGEBIETE (IPC)

H01J
H05H

Der vorliegende Recherchenbericht wurde für alle Patentansprüche erstellt

| Recherchenort | Abschlußdatum der Recherche | Prüfer |
|---|---|---|
| Den Haag | 15. November 2005 | Capostagno, E |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

13

**ANHANG ZUM EUROPÄISCHEN RECHERCHENBERICHT
ÜBER DIE EUROPÄISCHE PATENTANMELDUNG NR.**

EP 05 01 4414

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-11-2005

| Im Recherchenbericht angeführtes Patentdokument | | Datum der Veröffentlichung | Mitglied(er) der Patentfamilie | | | Datum der Veröffentlichung |
|---|---|---|---|---|---|---|
| US 5637961 | A | 10-06-1997 | JP | 3140934 | B2 | 05-03-2001 |
| | | | JP | 8115799 | A | 07-05-1996 |
| | | | KR | 158518 | B1 | 01-02-1999 |
| WO 9801946 | A | 15-01-1998 | AU | 3567997 | A | 02-02-1998 |
| | | | AU | 3568097 | A | 02-02-1998 |
| | | | WO | 9801964 | A1 | 15-01-1998 |
| WO 0017906 | A | 30-03-2000 | EP | 1147544 | A2 | 24-10-2001 |
| | | | JP | 2002525866 | T | 13-08-2002 |
| | | | TW | 434638 | B | 16-05-2001 |
| US 4864587 | A | 05-09-1989 | KEINE | | | |
| US 2004263412 | A1 | 30-12-2004 | KEINE | | | |
| US 6667487 | B1 | 23-12-2003 | KEINE | | | |
| US 2003215373 | A1 | 20-11-2003 | AU | 2003226071 | A1 | 12-12-2003 |
| | | | CN | 1656593 | A | 17-08-2005 |
| | | | EP | 1506564 | A2 | 16-02-2005 |
| | | | JP | 2005527078 | T | 08-09-2005 |
| | | | WO | 03101160 | A2 | 04-12-2003 |

EPO FORM P0461

Für nähere Einzelheiten zu diesem Anhang : siehe Amtsblatt des Europäischen Patentamts, Nr.12/82